(19) Europäisches Patentamt
European Patent Office
Office européen des brevets

(11) **EP 2 369 033 A1**

(12) **EUROPÄISCHE PATENTANMELDUNG**

(43) Veröffentlichungstag:
   **28.09.2011 Patentblatt 2011/39**

(51) Int Cl.:
   *C23C 14/24* (2006.01)   *C23C 14/56* (2006.01)

(21) Anmeldenummer: **10157912.6**

(22) Anmeldetag: **26.03.2010**

(84) Benannte Vertragsstaaten:
   **AT BE BG CH CY CZ DE DK EE ES FI FR GB GR HR HU IE IS IT LI LT LU LV MC MK MT NL NO PL PT RO SE SI SK SM TR**
   Benannte Erstreckungsstaaten:
   **AL BA ME RS**

(71) Anmelder: **Saint-Gobain Glass France**
   **92400 Courbevoie (FR)**

(72) Erfinder:
   • **Jahnke, Andreas**
     **81827, München (DE)**

   • **Boger, Raimund**
     **89231 Neu-Ulm (DE)**
   • **Götze, Thomas**
     **04886, Großtreben (DE)**

(74) Vertreter: **Lendvai, Tomas**
   **Saint-Gobain Sekurit Deutschland GmbH & Co. KG**
   **Patentabteilung**
   **Glasstrasse 1**
   **52134 Herzogenrath (DE)**

(54) **Verfahren zum Nachfüllen einer Verdampferkammer**

(57)    Verfahren zum kontinuierlichen Nachfüllen einer Verdampferkammer, wobei

a. zu verdampfendes Material (1) über eine Zuführung (6) und einen geheizten Vakuumschiebers (2) in einen Siphon (4) innerhalb einer beheizten Vakuumkammer (3) überführt wird,

b. zu verdampfendes Material (1) im Siphon (4) bis zur Verflüssigung aufgeheizt wird und

c. zu verdampfendes Material (1) über einen mit dem Ausgang des Siphons (4) verbundenen Trichter (7) in eine Wanne (9) innerhalb einer Verdampferkammer (8) überführt wird.

FIGUR 1

## Beschreibung

Die Erfindung betrifft ein Verfahren und eine Vorrichtung zum Nachfüllen einer Verdampferkammer, insbesondere zum kontinuierlichen Nachfüllen der Verdampferkammer.

Einer der Vorteile von Dünnschichtsolarzellen gegenüber Solarzellen mit kristallinem oder polykristallinem Silizium ist ihre große Flexibilität im Hinblick auf das verwendete Substrat und die Größe des zu beschichtenden Substrats. So lassen sich Dünnschichtsolarzellen auch großflächig auf Glasscheiben oder auf flexiblen Materialien, wie beispielsweise Kunststoffen herstellen.

Photovoltaische Schichtsysteme zur direkten Umwandlung von Sonnenstrahlung in elektrische Energie sind hinreichend bekannt. Die Materialien und die Anordnung der Schichten sind so abgestimmt, dass einfallende Strahlung von einer oder mehreren halbleitenden Schichten mit möglichst hoher Strahlungsausbeute direkt in elektrischen Strom umgewandelt wird. Photovoltaische und flächig ausgedehnte Schichtsysteme werden als Solarzellen bezeichnet.

Solarzellen enthalten in allen Fällen Halbleitermaterial. Solarzellen, die zur Bereitstellung einer ausreichenden mechanischen Festigkeit Trägersubstrate benötigen, werden als Dünnschichtsolarzellen bezeichnet. Aufgrund der physikalischen Eigenschaften und der technologischen Handhabbarkeit sind Dünnschichtsysteme mit amorphem, mikromorphem oder polykristallinem Silizium, Cadmium-Tellurid (CdTe), Gallium-Arsenid (GaAs) oder Kupfer-Indium(Gallium)-Schwefel/Selen (CI(G)S) besonders für Solarzellen geeignet.

Bekannte Trägersubstrate für Dünnschichtsolarzellen enthalten anorganisches Glas, Polymere oder Metalllegierungen und können in Abhängigkeit von Schichtdicke und Materialeigenschaften als starre Platten oder biegsame Folien ausgestaltet sein. Aufgrund der weitreichend verfügbaren Trägersubstrate und einer einfachen monolithischen Integration können großflächige Anordnungen von Dünnschichtsolarzellen kostengünstig hergestellt werden.

Dünnschichtsolarzellen zeigen allerdings im Vergleich zu Solarzellen mit kristallinem oder multikristallinem Silizium eine geringere Strahlungsausbeute und einen geringeren elektrischen Wirkungsgrad. Dünnschichtsolarzellen basierend auf $Cu(In, Ga)(S,Se)_2$ zeigen elektrische Wirkungsgrade, die annähernd mit multikristallinen Silizium-Solarzellen vergleichbar sind. CI(G)S-Dünnschichtsolarzellen benötigen eine Pufferschicht zwischen typisch p-leitendem CI(G)S-Absorber und typisch n-leitender Frontelektrode, die üblicherweise Zinkoxid (ZnO) umfasst. Die Pufferschicht kann eine elektronische Anpassung zwischen Absorbermaterial und Frontelektrode bewirken. Die Pufferschicht enthält beispielsweise eine Cadmium-Schwefel-Verbindung. Eine Rückelektrode mit beispielsweise Molybdän wird direkt auf Trägersubstraten abgeschieden.

Eine elektrische Schaltung von mehreren Solarzellen wird als Photovoltaik-oder Solarmodul bezeichnet. Die Schaltung von Solarzellen wird in bekannten witterungsstabilen Aufbauten dauerhaft vor Umwelteinflüssen geschützt. Üblicherweise sind eisenarme Natron-Kalk-Gläser und haftvermittelnde Polymerfolien mit den Solarzellen zu einem bewitterungsstabilen Photovoltaikmodul verbunden. Die Photovoltaikmodule können über Anschlussdosen in eine Schaltung von mehreren Photovoltaikmodulen eingebunden sein. Die Schaltung von Photovoltaikmodulen ist über bekannte Leistungselektronik mit dem öffentlichen Versorgungsnetz oder einer autarken elektrischen Energieversorgung verbunden.

Die Abscheidung von Selen, insbesondere bei der sequenziellen Abscheidung der Komponenten der CIS-Schicht, erfolgt in der Regel im Vakuum. Dies bedingt eine vollständige Unterbrechung des Prozesses, wenn das zur Abscheidung vorgesehene Selen aufgebraucht ist. Die gesamte Apparatur muss belüftet, abgekühlt, Selen in die Apparatur nachgefüllt und anschließend wieder evakuiert und erwärmt werden. Diese Schritte sind sehr zeitaufwendig und bei einer großtechnischen Produktion sehr kostenintensiv, da der Verdampfungsprozess jeweils für einen längeren Zeitraum unterbrochen wird. Durch diese notwendigen Schritte, insbesondere die Belüftungsund Abkühlprozesse, ist eine kontinuierliche Selenbedampfung nicht möglich. Da die Größe der Verdampfungsvorrichtung und die Selendampfkonzentration wichtige Prozessparameter sind, kann zudem nicht beliebig viel Selen in die Selenverdampferkammer eingebracht werden. Zudem ist die Geschwindigkeit einer gleichmäßigen Selenverdampfung auch von einem definierten Oberfläche- zu Volumenverhältnis des zu verdampfenden Selens abhängig.

WO 2007/077171 A2 offenbart ein Verfahren zur Herstellung von Chalkopyritschichten in CIGSS - Solarzellen. Dazu wird ein Substrat mit Precursorn beschichtet und zusammen mit Schwefel und Selen in eine dicht verschließbare Reaktionsbox gelegt. Die Reaktionsbox wird in einen RTP- Ofen gebracht, evakuiert und auf die notwendige Reaktionstemperatur erhitzt.

EP 0 715 358 A2 offenbart ein Verfahren zur Herstellung einer Solarzelle mit Chalkopyrit-Absorberschicht. Im Verfahren wird durch Zugabe von Na, K oder Li ein gewünschter Alkaligehalt eingestellt. Eine zusätzliche Diffusion von Alkaliionen aus dem Substrat wird durch eine Diffusionssperrschicht verhindert. Selen und/oder Schwefel werden im Verfahren zumindest teilweise über eine entsprechende schwefeloder selenhaltige Atmosphäre zugeführt.

WO 2009/034131 A2 offenbart ein Verfahren zum Abscheiden von Chalkogenen in dünnen Schichten. Das Selen wird als Festkörper in einem Vorratsgefäß gelagert und von dort in eine Kammer überführt und verdampft. Die Kammer ist am Eingang mit einem Verschluss versehen, um ein Entweichen der Selendämpfe in das Vorratsgefäß zu vermeiden.

US 4,880,960 A offenbart ein Verfahren zur Vakuumverdampfung und eine Vorrichtung zur Beschichtung eines beweglichen Substrats. Das aufzutragende Material wird kontinuierlich aus einem Vorratsbehälter über ein Ventil in eine Vakuumkammer überführt, erhitzt und dort auf ein auf Rollen gelagertes Substrat aufgedampft. Die Erfindung offenbart die Bedampfung von Kohlefasern mit Magnesium.

WO 2009/010468 A1 offenbart eine Vorrichtung zum Verdampfen fester Materialien. Das feste Material, beispielsweise Selen, wird in einen ersten Tiegel gebracht und aufgeschmolzen. Das geschmolzene Material fließt über eine Transportvorrichtung in einen zweiten Tiegel. In diesem Tiegel wird das geschmolzene Material verdampft und auf ein Substrat gebracht. Das Einfüllen des Materials erfolgt in ein Reservoir, das nach dem Befüllen geschlossen, sowie anschließend evakuiert wird und über ein Ventil das feste Material zum ersten Tiegel durchlässt.

Die Aufgabe der vorliegenden Erfindung liegt darin, ein Verfahren bereitzustellen, das ein kontinuierliches Nachfüllen einer Verdampferkammer ermöglicht, ohne die Verdampfung, insbesondere die Verdampfung von Selen, Schwefel, Tellur und/oder Gemischen davon zu unterbrechen.

Die Aufgabe der vorliegenden Erfindung wird erfindungsgemäß durch ein Verfahren zum kontinuierlichen Nachfüllen einer Verdampferkammer gemäß Anspruch 1 gelöst. Bevorzugte Ausführungen gehen aus den Unteransprüchen hervor.

Erfindungsgemäße Vorrichtungen und deren Verwendung gehen aus weiteren nebengeordneten Ansprüchen hervor.

Das erfindungsgemäße Verfahren zum Nachfüllen einer Verdampferkammer umfasst in einem ersten Schritt das Einfüllen von bevorzugt festem Material über eine Zuführung in einen Siphon innerhalb einer beheizten Vakuumkammer. Ein zwischen der Zuführung und der Vakuumkammer angebrachter und auf 160 °C bis 200 °C geheizter Vakuumschieber ermöglicht das Öffnen und Schließen der Vakuumkammer. Ist die Selenzufuhr abgeschlossen, so wird der geheizte Vakuumschieber geschlossen Die Vakuumkammer weist nach dem Schließen des geheizten Vakuumschiebers durch Anlegen eines Vakuums einen Druck $p_1$ auf. Das in dem Siphon befindliche Material wird über eine Heizung in der Vakuumkammer verflüssigt und kann in Abhängigkeit vom Druckunterschied zwischen den beiden Enden des Siphons über einen mit dem Ende des Siphons verbundenen Trichter in eine Wanne einer angeschlossenen Verdampferkammer überführt werden. Die Verdampferkammer und der Ausgang des Siphons weisen bevorzugt einen Druck $p_2$ auf, wobei der Druck $p_2$ kleiner als der Druck $p_1$ in der Vakuumkammer am Eingang des Siphons ist.

Das Material umfasst bevorzugt Selen, Schwefel, Jod, Bismut, Blei, Cadmium, Cäsium, Gallium, Indium, Rubidium, Tellur, Thallium, Zinn, Zink und/oder Gemische davon, besonders bevorzugt Schwefel, Selen und/oder Tellur, insbesondere bevorzugt Selen.

Die Temperierung des geheizten Vakuumschiebers erfolgt bevorzugt durch ein am Vakuumschieber angebrachtes geheiztes Verbindungsstück und/oder gekühltes Verbindungsstück.

Die Temperierung des geheizten Vakuumschiebers kann alternativ auch direkt im geheizten Vakuumschieber, bevorzugt über eine elektrische Widerstandsheizung erfolgen.

Der geheizte Vakuumschieber und/oder das geheizte Verbindungsstück werden bevorzugt auf 160 °C bis 200 °C temperiert.

Das gekühlte Verbindungsstück wird bevorzugt auf 25 °C bis 35 °C temperiert, diese Temperatur verhindert ein Verkleben des festen Materials am Verbindungsstück.

Der Siphon wird bevorzugt auf 200 °C bis 250 °C erwärmt, um das im Siphon befindliche Material zu verflüssigen.

Die Vakuumkammer wird bevorzugt auf einen Druck $p_1$ von 20 mbar bis $10^{-6}$ mbar, bevorzugt 10 mbar bis 0,1 mbar evakuiert.

Die Verdampferkammer wird bevorzugt auf einen Druck $p_2$ von $10^{-2}$ mbar bis $10^{-7}$ mbar evakuiert.

Die Verdampferkammer wird bevorzugt auf eine Temperatur von 200 °C bis 300 °C, bevorzugt 230 °C bis 270 °C erwärmt.

Der Druck $p^1$ in der Vakuumkammer ist bevorzugt um mindestens $10^1$ mbar, bevorzugt um $10^2$, besonders bevorzugt um $10^3$ mbar größer als der Druck $p_2$ in der Verdampferkammer.

Die Erfindung umfasst des Weiteren eine Vorrichtung zum kontinuierlichen Nachfüllen einer Verdampferkammer. Die Vorrichtung umfasst mindestens eine Zuführung für bevorzugt festes Material und einen an der Zuführung angebrachten, geheizten Vakuumschieber. An dem geheizten Vakuumschieber ist eine Vakuumkammer befestigt. Innerhalb der Vakuumkammer ist ein Siphon mit dem geheizten Vakuumschieber verbunden und die Öffnung des geheizten Vakuumschiebers ermöglicht ein Nachfüllen des Siphons mit bevorzugt festem Material aus der Zuführung. Eine in der Vakuumkammer angebrachte Heizung ermöglicht ein Erwärmen und Verflüssigen des im Siphon befindlichen Materials. In einer an der Vakuumkammer angebrachten Verdampferkammer ist ein Trichter mit dem Ausgang des Siphons verbunden. Der Trichter ist mit einer in der Verdampferkammer befindlichen Verdampfungswanne verbunden. Die Verdampfungswanne ermöglicht das Verdampfen des über den Trichter eingeleiteten flüssigen Materials.

Der Siphon enthält bevorzugt eine Flüssigkeit. Die Flüssigkeit verhindert ein Eindringen von Materialdämpfen aus der Verdampferkammer in die Vakuumkammer. Die Flüssigkeit ermöglicht des Weiteren die Einstellung unterschiedlicher Druckniveaus in der Vakuumkammer und der Verdampferkammer. Für die Steighöhe, d.h. für den Unterschied in der Höhe der Flüssigkeitssäulen in den Schenkeln des Siphons gilt dabei Gleichung (1):

$$\Delta h = \frac{\Delta p}{\rho * g} \qquad\qquad (1),$$

mit $\Delta p$ = Druckunterschied zwischen Verdampferkammer und Vakuumkammer (Pa), $\Delta h$ = Niveau-Unterschied in den Schenkeln des Siphons (mm), $\rho$ = spezifische Dichte der Flüssigkeit (g/cm$^3$) und g = Gravitationskonstante (9,81 m/s$^2$).

Die Flüssigkeit enthält bevorzugt Selen, Schwefel, Jod, Bismut, Blei, Cadmium, Cäsium, Gallium, Indium, Rubidium, Tellur, Thallium, Zinn, Zink und/oder Gemische davon, besonders bevorzugt Selen. Die Flüssigkeit weist bevorzugt einen Schmelzpunkt von weniger als 450 °C und einen Dampfdruck von weniger 5 mbar am Schmelzpunkt auf. Die Flüssigkeit schließt die Vakuumkammer von der Verdampferkammer ab und ermöglicht die Einstellung unterschiedlicher Druckniveaus in beiden Kammern. Die Flüssigkeit entspricht bevorzugt in der Zusammensetzung dem festen Material und ermöglicht ein kontinuierliches Nachfüllen der Verdampferkammer.

Der geheizte Vakuumschieber weist bevorzugt eine Öffnung mit einem Durchmesser von 15 mm bis 50 mm, bevorzugt 30 mm bis 40 mm auf. Die Durchlässigkeit für das Material wird durch Verschieben der Öffnung im geheizten Vakuumschieber geregelt.

Der geheizte Vakuumschieber ist bevorzugt oberhalb in Richtung der Zuführung mit einem gekühlten Verbindungsstück und/oder unterhalb in Richtung der Vakuumkammer mit einem geheizten Verbindungsstück verbunden.

Das gekühlte Verbindungsstück und/oder das geheizte Verbindungsstück enthalten bevorzugt eine Lochplatte mit einer Öffnung und einer Heizung oder Kühlung, ein mechanisches Gegenlager, einen Verschluss, einen Schieber und ein Schiebergehäuse. Das Schiebergehäuse und der Schieber sind außen am gekühlten Verbindungsstück und/ oder am geheizten Verbindungsstück angebracht. Der Schieber ist über eine Bohrung am Schiebergehäuse und Verbindungsstück mit dem Innenraum des Verbindungsstücks verbunden. Die Lochplatte und der Verschluss ermöglichen, abhängig von der Stellung des Schiebers, eine Durchlässigkeit oder Undurchlässigkeit für das Material sowie ein Einstellen des Vakuums oder ein Belüften der benachbarten Verbindungsstücke. Der Schieber ist bevorzugt direkt mit dem Verschluss verbunden. Befinden sich die Öffnung des Verschlusses und die Öffnung der Lochplatte deckungsgleich übereinander, so ist die Anordnung für das Material durchlässig. Im anderen Fall, haben die Öffnung des Verschlusses und die Öffnung der Lochplatte keine gemeinsame Deckungsfläche, so ist die Anordnung für das Material undurchlässig. Die Kühlung und/oder Heizung ist bevorzugt in Form einer Kühlschleife oder elektrischen Widerstandsheizung an der Lochplatte und/oder dem Verschluss, besonders bevorzugt umfänglich um die Öffnung der Lochplatte und/oder die Öffnung des Verschlusses angeordnet. Die Anordnung aus Lochplatte und Verschluss sind bevorzugt im 90° Winkel zur Einführrichtung des Materials angeordnet.

Die Erfindung umfasst des Weiteren eine alternative Ausgestaltung der Vorrichtung. Die Vorrichtung umfasst eine Vakuumschleuse für festes Material und eine an der Vakuumschleuse angebrachte Vakuumkammer. Prinzipiell kann jede Art von Schleusenanordnung verwendet werden, um festes Material in die Vakuumkammer zu transferieren und welche gegenüber dem Druckunterschied von Atmosphärendruck und dem Vakuum in der Verdampferkammer stabil ist. Die Vakuumschleuse umfasst bevorzugt ein gekühltes Verbindungsstück, einen geheizten Vakuumschieber und/oder ein geheiztes Verbindungsstück. Die Vakuumkammer ist mit einer Trennwand versehen. Die Trennwand weist bevorzugt zum Boden der Vakuumkammer einen Schlitz auf, welcher nur für flüssiges Material durchgängig ist. Alternativ kann die Trennwand auch als poröse Wand vorliegen, welche für flüssiges Material durchlässig ist. Die Passage kleiner fester Partikel ist in diesem Zusammenhang nicht problematisch. An der Vakuumkammer ist ein Verbindungskanal in eine Verdampferkammer angebracht. Die Trennwand trennt den Einfüllbereich der Verdampferkammer vom dem Bereich der Vakuumkammer wo der Verbindungskanal angeschlossen ist. Eine Heizummantelung umschließt die Vakuumkammer und den Verbindungskanal. Die Heizummantelung liegt bevorzugt in Form eines Heizbades, besonders bevorzugt eines umwälzbaren Heizbades vor. Am Verbindungskanal ist eine schaltbare Kühlvorrichtung angebracht. Die schaltbare Kühlvorrichtung ist bevorzugt in Form von Röhren lokal um den Verbindungskanal angeordnet. Der Ausdruck "lokal" bezieht sich dabei nur auf einen Teilbereich des Verbindungskanals, bevorzugt 1 % bis 30 %, besonders bevorzugt 2 % bis 8 % der Oberfläche des Verbindungskanals. Bei eingeschaltetem Kühlmittelfluss wird der Verbindungskanal im Bereich der schaltbaren Kühlvorrichtung abgekühlt und bewirkt so ein Erstarren des flüssigen Materials. Das erstarrte Material schließt die Vakuumkammer von der Verdampferkammer ab. Bei abgestelltem Kühlmittelfluss wird das Material wieder flüssig und die Vakuumkammer ist über den Verbindungskanal direkt mit der Verdampferkammer verbunden.

Die Heizummantelung enthält bevorzugt eine Heizflüssigkeit, bevorzugt ein temperaturbeständiges Mineralöl und/oder Silikonöl.

Die Heizummantelung weist bevorzugt eine Einfüllvorrichtung und eine Ausfüllvorrichtung auf. Die Einfüllvorrichtung und Ausfüllvorrichtung sind bevorzugt röhrenförmig und mit einer Pumpe, bevorzugt Ölpumpe verbunden. Die Pumpe ermöglicht das Umwälzen einer Heizflüssigkeit in der Heizummantelung. Innerhalb eines im Bereich von 150 °C bis 350 °C temperaturbeständigen Behälters umfließt die Heizflüssigkeit bevorzugt direkt die Vakuumkammer und den Verbindungskanal und ermöglicht so eine konstante Temperierung.

Die Vakuumkammer, der Verbindungskanal, die Einfüllvorrichtung und/oder die Ausfüllvorrichtung enthalten bevorzugt einen Überzug aus Emaille und/oder Teflon.

Die Heizummantelung ist bevorzugt von einem Spiralblech umgeben. Das Spiralblech ist besonders bevorzugt im Bereich des Verbindungskanals um die Heizummantelung angeordnet und ermöglicht eine zusätzliche Beheizung des Verbindungskanals. Das Spiralblech kann auch zur Verflüssigung des im Bereich der schaltbaren Kühlvorrichtung bei eingeschalteter Kühlung vorliegenden festen Materials dienen.

Die Trennwand enthält bevorzugt ein Metall oder Kohlenstoff, besonders bevorzugt Graphit. Die Trennwand kann auch netz- oder wabenförmig ausgebildet sein, die Öffnungen sind bevorzugt so ausgeführt, dass sie festes Material zurückhalten und für flüssiges Material durchlässig sind.

Die Kühlvorrichtung enthält bevorzugt ein Kühlmittel. Das Kühlmittel wird bevorzugt über einen Kryostaten und eine Umwälzpumpe durch die Kühlvorrichtung gepumpt. Das Kühlmittel enthält bevorzugt organische und/oder anorganische Lösungsmittel, bevorzugt Glykol, Ethylenglykol und/oder Wasser.

Die Erfindung umfasst des Weiteren die Verwendung der erfindungsgemäßen Vorrichtung zum kontinuierlichen Nachfüllen einer Verdampferkammer für Schwefel, Selen, Tellur und/oder Gemischen davon.

Die Erfindung umfasst des Weiteren die Verwendung der Vorrichtung zum kontinuierlichen Nachfüllen einer Selenverdampferkammer bei der Herstellung von Dünnschichtsolarzellen.

Im Folgenden wird die Erfindung anhand einer Zeichnung näher erläutert. Die Zeichnung ist eine rein schematische Darstellung und nicht maßstabsgetreu. Die Zeichnung schränkt die Erfindung in keiner Weise ein.

Es zeigen:

Figur 1 einen Querschnitt einer bevorzugten Ausführungsform der erfindungsgemäßen Vorrichtung,

Figur 2 ein Schema der einzelnen Komponenten der Kühlvorrichtung/Heizvorrichtung (15),

Figur 3 einen Querschnitt einer alternativen Ausführungsform der erfindungsgemäßen Vorrichtung,

Figur 4 ein Fliessdiagramm einer bevorzugten Ausführungsform des erfindungsgemäßen Verfahrens und

Figur 5 einen Querschnitt einer weiteren bevorzugten Ausführungsform der erfindungsgemäßen Vorrichtung.

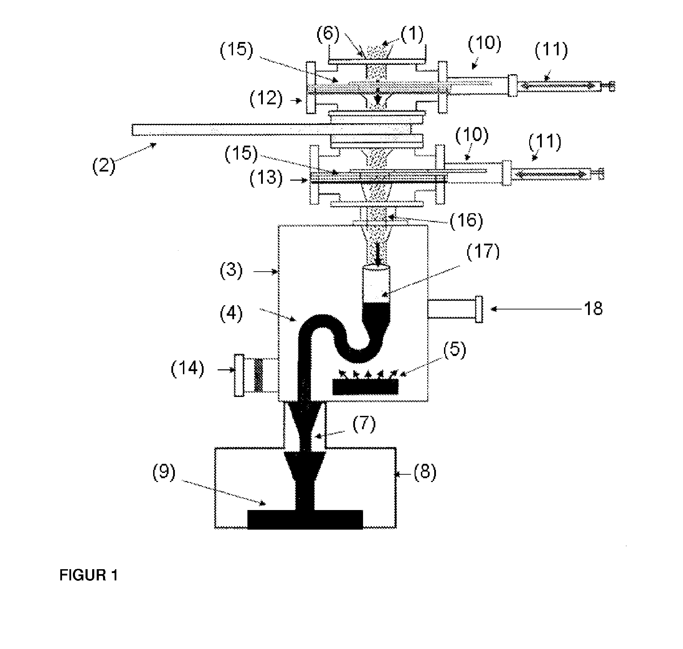

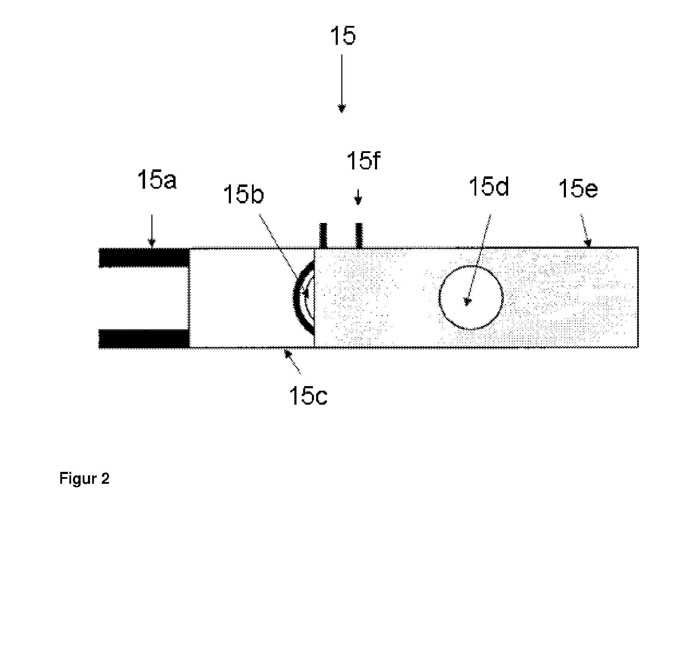

Figur 1 zeigt einen Querschnitt durch eine bevorzugte Ausführungsform der erfindungsgemäßen Vorrichtung. Als Material (1) wird Selen (1) über die Zuführung (6) in die erfindungsgemäße Vorrichtung eingefüllt und zur Verdampferkammer (8) befördert. Um das Vakuum in der Verdampferkammer (8) nicht zu beeinflussen, erfolgt die Zugabe des Selens (1) zur Verdampferkammer (8) über einen geheizten Vakuumschieber (2). Die erfindungsgemäße Vorrichtung umfasst nach der Zuführung (6) ein gekühltes Verbindungsstück (12), einen geheizten Vakuumschieber (2) und ein geheiztes Verbindungsstück (13). Das gekühlte Verbindungsstück (12) verhindert ein Verkleben des festen Selens (1) beim Einfüllen. Das geheizte Verbindungsstück (13) verhindert ein Kondensieren vom gasförmigen Selen (1) aus der erfindungsgemäßen Vorrichtung. Die Verbindungsstücke (12,13) liegen als Kreuzstücke in den Abmessungen 210 mm x 210 mm vor. Das gekühlte Verbindungsstück (12) und das geheizte Verbindungsstück (13) enthalten ein Schiebergehäuse (10) in einer Länge von 75 mm sowie einen Schieber (11) in einer Länge von 105 mm. Der Schieber (11) kann auf einer Länge von 50 mm innerhalb des Schiebergehäuses (10) verschoben werden. Der Schieber (11) kann die Durchlässigkeit für Selen (1) innerhalb der Vorrichtung regulieren. So können durch gezieltes Öffnen oder Schließen der Schieber (11) und die damit verbundene Kühl-/Heizvorrichtung (15), die einzelnen Abschnitte der Vorrichtung für Selen durchgängig sein oder nicht. Der geheizte Vakuumschieber (2) reguliert den Druck und dient zum Evakuieren und Belüften. So kann die Vakuumkammer (3) evakuiert werden, wenn das gekühlte Verbindungsstück (12), der geheizte Vakuumschieber (2) und das geheizte Verbindungsstück (13) zur Verdampferkammer (8) hin geschlossen sind. Die Funktionsweise der Kühl-/Heizvorrichtung (15) wird in Figur 2 erläutert. Die beiden Verbindungsstücke (12/13) regeln oder sperren die Durchlässigkeit des Selens (1) und werden über die Kühl-/Heizvorrichtung (15) temperiert. Der geheizte Vakuumschieber (2) reguliert den Druck. Nach Passieren des geheizten Verbindungsstücks (13) gelangt das Selen (1) über einen Förderkanal (16) in einen Siphon (4) in einer Vakuumkammer (3). Über ein Verbindungsstück (18) lässt sich die Vakuumkammer (3) evakuieren. Eine Heizung (5) erwärmt das im Siphon (4) befindliche Selen (1). Die Höhe der Flüssigkeitssäule (17) des Selens (1) ergibt sich aus dem Druckunterschied zwischen der Vakuumkammer (3) und der angeschlossenen Verdampferkammer (8). Über ein Sichtfenster (14) lässt sich die Höhe der Flüssigkeitssäule verfolgen. Der Siphon (4) ist über einen Trichter (7) in der Verdampferkammer (8) mit einer Wanne (9) zum Verdampfen des Selens (1) verbunden.

Figur 2 zeigt ein Schema der Kühl-/Heizvorrichtung (15) im halb geschlossenen Zustand. Auf einem mechanischen Gegenlager (15a) ist eine Lochplatte (15c) angeordnet. Die Öffnung der Lochplatte (15b) ist von einer Kühlung oder Heizung (15f) umgeben. Der Verschluss (15e) mit der Öffnung im Verschluss (15d) regelt die Durchlässigkeit der Kühl-/Heizvorrichtung (15) für das Material (1). Sind die Öffnung der Lochplatte (15b) und die Öffnung im Verschluss (15d) deckungsgleich übereinander angeordnet, so ist die Kühl-/Heizvorrichtung (15) durchlässig und entsprechend undurchlässig, wenn der Verschluss (15e) geschlossen über der Öffnung der Lochplatte (15b) liegt. Die Kühl-/Heizvorrichtung (15) ist wie in Figur 1 gezeigt, bevorzugt in etwa 90° Winkel zur Einfüllrichtung des Materials (1) angeordnet, wobei die Öffnung der Lochplatte (15b) sich senkrecht zur Einfüllrichtung des Materials (1) befindet. Die Position des Verschlusses (15e) über der Lochplatte (15c) wird über die in Figur 1 beschriebene Anordnung aus Schieber (11) und Schiebergehäuse (10) geregelt. Der Schieber (11) ist bevorzugt direkt mit dem Verschluss (15e) verbunden.

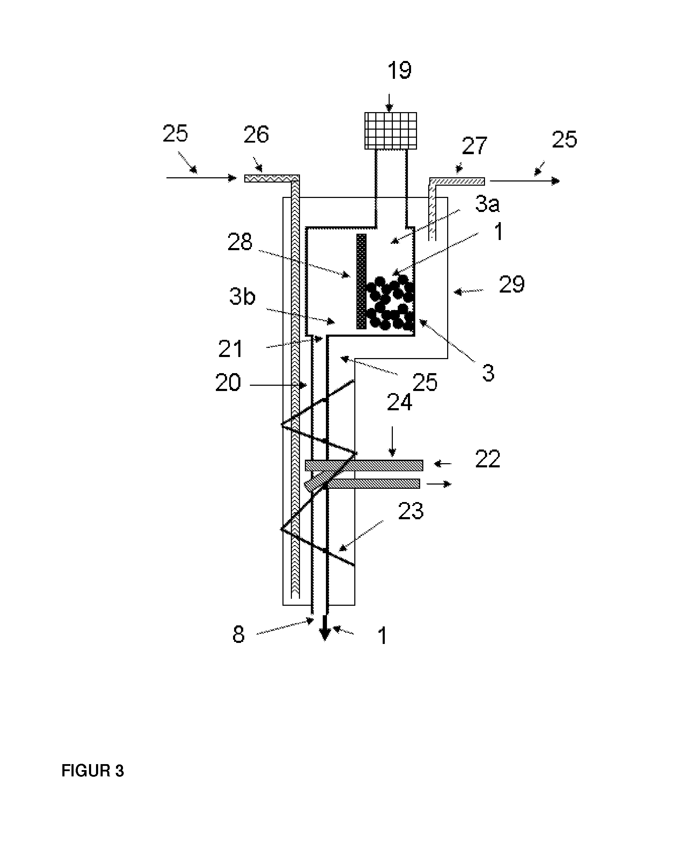

Figur 3 zeigt einen Querschnitt einer bevorzugten alternativen Ausführungsform der erfindungsgemäßen Vorrichtung. Selen (1) gelangt über eine Vakuumschleuse (19) in eine Vakuumkammer (3). Die Vakuumkammer (3) ist durch eine Trennwand (28) in zwei Bereiche (3a/3b) geteilt. Im Anschluss an die Vakuumschleuse (19) befindet sich das eingefüllte Selen (1) vor der Trennwand (28) im Einfüllbereich (3a) der Vakuumkammer (3). Die Trennwand (28) ist nur für flüssiges Selen durchlässig. Eine Heizummantelung (29) erwärmt und verflüssigt das Selen (1), so dass das Selen (1) die Trennwand (28) passieren kann und in den Ausflussbereich (3b) gelangt. Die Heizummantelung (29) umfasst bevorzugt eine Außenhülle aus Metall, bevorzugt Eisen, Chrom Vanadium Aluminium, Titan und/oder Edelstahl, in der sich die Heizflüssigkeit (25) und die Anordnung aus Vakuumkammer (3) und Verbindungskanal (20) befinden. Die Heizummantelung (29) enthält eine Einfüllvorrichtung (26) und eine Auslassvorrichtung (27), über die die Heizflüssigkeit (25), beispielsweise ein hochtemperaturstabiles Silikonöl, innerhalb der Heizummantelung (29) umgewälzt werden kann. Das flüssige Selen (1) gelangt über einen Abfluss (21) in den Verbindungskanal (20) und in die nicht gezeigte Verdampferkammer (8). Eine am Verbindungskanal (20) angebrachte schaltbare Kühlvorrichtung (24) kann bei eingeschaltetem Kühlmittelfluss (22) flüssiges Selen (1) im Verbindungskanal (20) verfestigen und den Verbindungskanal (20) verschließen. Ein an der Heizummantelung (29) im Bereich des Verbindungskanals (20) angebrachtes Spiralblech (23) erzwingt eine Strömung der Heizflüssigkeit (25), die bei abgeschalteter Kühlvorrichtung (24) den Verbindungskanal (20) wieder erwärmt. Das Spiralblech (23) kann auch zur Verflüssigung des im Bereich der schaltbaren Kühlvorrichtung (24) vorliegenden festen Selens (1) dienen.

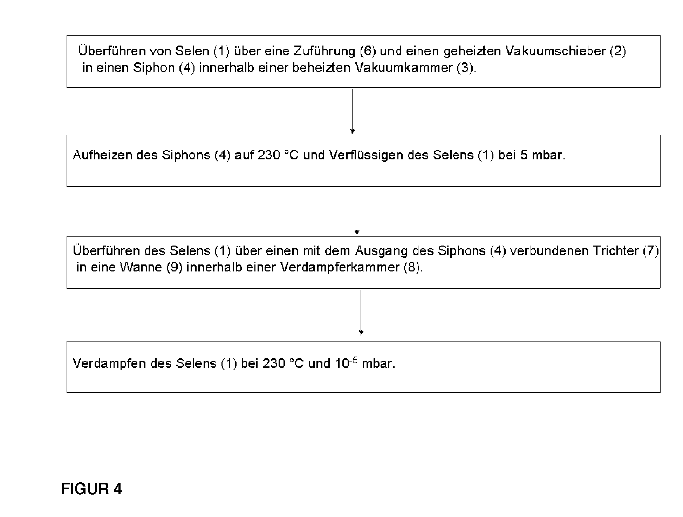

Figur 4 zeigt ein Fliessdiagramm einer bevorzugten Ausführungsform des erfindungsgemäßen Verfahrens. In einem ersten Schritt wird festes Selen (1) über eine Zuführung (6) in einen Siphon (4) innerhalb einer beheizten Vakuumkammer (3) überführt. Ein zwischen der Zuführung (6) und der Vakuumkammer (3) angebrachter und auf 160 °C bis 200 °C geheizter Vakuumschieber (2) ermöglicht das Öffnen und Schließen der Vakuumkammer (3). Ist die Selenzufuhr abgeschlossen, so wird der geheizte Vakuumschieber (2) geschlossen Die Vakuumkammer (3) weist nach dem Schließen des geheizten Vakuumschiebers (2) durch Anlegen eines Vakuums einen Druck von 5 mbar auf. Das in dem Siphon (4) befindliche Selen (1) wird über eine Heizung (5) in der Vakuumkammer (3) bei 230 °C verflüssigt und über einen mit dem Ende des Siphons (4) verbundenen Trichter (7) in eine Wanne (9) einer angeschlossenen Verdampferkammer (8) überführt werden. Die Verdampferkammer (8) und der Ausgang des Siphons (4) weisen bevorzugt einen Druck von $10^{-5}$ mbar und eine Temperatur von 230 °C auf.

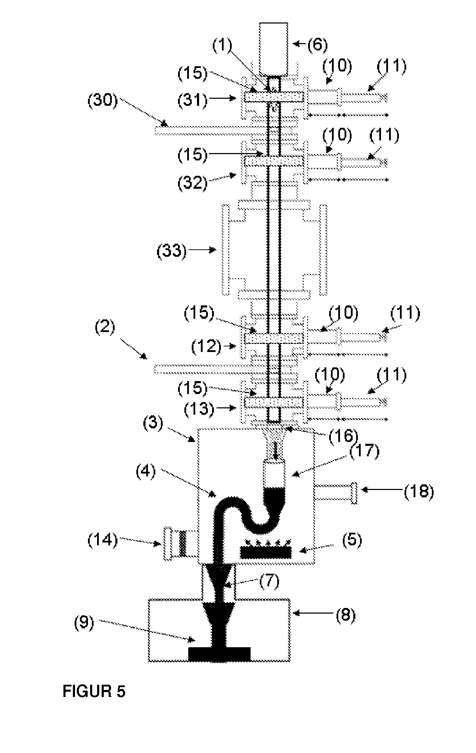

Figur 5 zeigt einen Querschnitt einer weiteren bevorzugten Ausführungsform der erfindungsgemäßen Vorrichtung. Der Aufbau der Vorrichtung entspricht dem in Figur 1 beschriebenen, mit dem Unterschied, dass zwischen der Zuführung (6) und dem gekühlten Verbindungsstück (12) ein erstes gekühltes Verbindungsstück (31), ein gekühlter Vakuumschieber (30), ein zweites gekühltes Verbindungsstück (32) und ein mittleres Verbindungsstück (33) angeordnet sind.

Beispiel

Die kontinuierliche Selen-Nachfüllung kann beispielhaft wie folgt erfolgen.

1. Festes Selen (1) wird in die Zuführung (6) eingefüllt (1 atm, 30°C, 300 g, alle 5 min)

2. Das mittlere Verbindungsstück (33), zweite gekühlte Verbindungsstück (32) und gekühlte Verbindungsstück (12) werden von 5 mbar auf 1 atm belüftet.

3. Öffnen des gekühlten Vakuumschiebers (30) und des Schiebers (11) im ersten gekühlten Verbindungsstück (31).

4. Öffnen des Schiebers (11) im zweiten gekühlten Verbindungsstück (32), damit das feste Selen (1) in die Vakuumschleuse bestehend aus zweitem gekühlten Verbindungsstück (32), mittlerem Verbindungsstück (33) und gekühlten Verbindungsstück (12) fallen kann. Dabei fällt das feste Selen (1) durch den gekühlten Vakuumschieber (30), durch das zweite gekühlte Verbindungsstück (32) und durch das mittlere Verbindungsstück (33) auf den Schieber (11) im gekühlten Verbindungsstück (12) (1 atm und 30°C, jeweils 300 g alle 5 min).

5. Schließen des Schiebers (11) im ersten gekühlten Verbindungsstück (31) und Schließen des gekühlten Vakuumschiebers (30) und des Schiebers (11) im zweiten gekühlten Verbindungsstück (32).

6. Das mittlere Verbindungsstück (33), zweite gekühlte Verbindungsstück (32) und gekühlte Verbindungsstück (12) mit festem Selen (1) werden von 1 atm auf 5 mbar evakuiert.

7. Öffnen des geheizten Vakuumschiebers (2) und des Schiebers (11) im ersten geheizten Verbindungsstück (13).

8. Öffnen des Schiebers (11) im gekühlten Verbindungsstück (12) damit das feste Selen (1) in den Siphon (4) fallen kann. Dabei fällt das feste Selen (1) (jeweils 300 g alle 5 min) durch den geheizten Vakuumschieber (2) und durch das geheizte Verbindungsstück (13) bei 160°C in den Siphon (4) bei 230°C und 5 mbar.

9. Heizen des festen Selens (1) im Siphon (4) mit der Heizung (5) bis es bei 230°C und 5 mbar schmilzt.

10. Kontinuierliches Fließen des flüssigen Selens (1) vom Siphon (4) durch den geheizten Trichter (7) in die Wanne (9) der Verdampferkammer (8) bei 10⁻ mbar und 230°C.

Bezugszeichenliste

| (1) | Material/Selen |
| (2) | geheizter Vakuumschieber |
| (3) | Vakuumkammer |
| (4) | Siphon |
| (5) | Heizung |
| (6) | Zuführung |
| (7) | Trichter |
| (8) | Verdampferkammer |
| (9) | Wanne |
| (10) | Schiebergehäuse |
| (11) | Schieber |
| (12) | gekühltes Verbindungsstück |
| (13) | geheiztes Verbindungsstück |
| (14) | Sichtfenster |
| (15) | Kühl-/Heizvorrichtung |
| (15a) | mechanisches Gegenlager |
| (15b) | Öffnung der Lochplatte |
| (15c) | Lochplatte |
| (15d) | Öffnung im Verschluss |

(15e)  Verschluss

(15f)  Kühlung/Heizung

(16)  Förderkanal

(17)  Höhe der Flüssigkeitssäule

(18)  Verbindungsstück

(19)  Vakuumschleuse

(20)  Verbindungskanal

(21)  Abfluss

(22)  Kühlmittel

(23)  Spiralblech

(24)  Kühlvorrichtung

(25)  Heizflüssigkeit

(26)  Einfüllvorrichtung

(27)  Auslassvorrichtung

(28)  Trennwand

(29)  Heizummantelung

(30)  gekühlter Vakuumschieber

(31)  erstes gekühltes Verbindungsstück

(32)  zweites gekühltes Verbindungsstück und

(33)  mittleres Verbindungsstück.

**Patentansprüche**

1.  Verfahren zum kontinuierlichen Nachfüllen einer Verdampferkammer, wobei

    a. Material (1) über eine Zuführung (6) und einen geheizten Vakuumschieber (2) in einen Siphon (4) innerhalb einer beheizten Vakuumkammer (3) überführt wird,
    b. Material (1) im Siphon (4) bis zur Verflüssigung aufgeheizt wird und
    c. Material (1) über einen mit dem Ausgang des Siphons (4) verbundenen Trichter (7) in eine Wanne (9) innerhalb einer Verdampferkammer (8) überführt wird.

2.  Verfahren nach Anspruch 1, wobei das Material (1) bevorzugt Selen, Schwefel, Brom, Jod, Bismut, Blei, Cadmium, Cäsium, Gallium, Indium, Rubidium, Tellur, Thallium, Zinn, Zink und/oder Gemische davon, besonders bevorzugt Selen enthält.

3.  Verfahren nach Anspruch 1 oder 2, wobei die Temperierung des geheizten Vakuumschiebers (2) durch ein daran angebrachtes gekühltes Verbindungsstück (12) und/oder geheiztes Verbindungsstück (13) erfolgt.

**4.** Verfahren nach einem der Ansprüche 1 bis 3, wobei der geheizte Vakuumschieber (2) auf 160 °C bis 200 °C temperiert wird.

**5.** Verfahren nach einem der Ansprüche 1 bis 4, wobei der Siphon (4) auf 200 °C bis 250 °C erwärmt wird.

**6.** Verfahren nach einem der Ansprüche 1 bis 5, wobei die Vakuumkammer (3) auf einen Druck $p_1$ von 20 mbar bis $10^{-6}$ mbar, bevorzugt 10 mbar bis 0,1 mbar evakuiert wird.

**7.** Verfahren nach einem der Ansprüche 1 bis 6, wobei die Verdampferkammer (8) auf einen Druck $p_2$ von $10^{-2}$ mbar bis $10^{-7}$ mbar evakuiert wird.

**8.** Verfahren nach einem der Ansprüche 1 bis 7, wobei die Verdampferkammer (8) auf eine Temperatur von 200 °C bis 300 °C, bevorzugt 230 °C bis 270 °C erwärmt wird.

**9.** Verfahren nach einem der Ansprüche 1 bis 8, wobei $p_1$ um mindestens $10^1$ mbar, bevorzugt um $10^2$ mbar, besonders bevorzugt um $10^3$ mbar größer als $p_2$ ist.

**10.** Vorrichtung zum kontinuierlichen Nachfüllen einer Verdampferkammer umfassend:

a. eine Zuführung (6) für Material (1) mit einem an der Zuführung (6) angebrachten, geheizten Vakuumschieber (2),
b. eine an dem geheizten Vakuumschieber (2) angebrachte Vakuumkammer (3) mit einem an dem geheizten Vakuumschieber (2) angebrachten Siphon (4) und einer Heizung (5) und
c. eine an der Vakuumkammer (3) angebrachte Verdampferkammer (8) mit einem an dem Siphon (4) angebrachten Trichter (7) und einer unter dem Trichter (7) angebrachten Verdampfungswanne (9).

**11.** Vorrichtung nach Anspruch 10, wobei der Siphon (4) eine Flüssigkeit, bevorzugt Selen, Schwefel, Jod, Bismut, Blei, Cadmium, Cäsium, Gallium, Indium, Rubidium, Tellur, Thallium, Zinn, Zink und/oder Gemische davon, besonders bevorzugt Selen enthält.

**12.** Vorrichtung nach einem der Ansprüche 10 bis 11, wobei die gekühlten/geheizten Verbindungsstücke (12/13) und/oder der geheizte Vakuumschieber (2) eine Öffnung (15d) mit einem Durchmesser von 15 mm bis 50 mm, bevorzugt 30 mm bis 40 mm aufweisen.

**13.** Vorrichtung nach einem der Ansprüche 10 bis 12, wobei der geheizte Vakuumschieber (2) oberhalb mit einen gekühlten Verbindungsstück (12) und/oder unterhalb mit einem geheizten Verbindungsstück (13) verbunden ist.

**14.** Vorrichtung nach einem der Ansprüche 10 bis 13, wobei das gekühlte Verbindungsstück (12) und/oder das geheizte Verbindungsstück (13) eine Lochplatte (15c) mit einer Öffnung (15b) und einer Heizung/Kühlung (15f), ein mechanisches Gegenlager (15a), einen Verschluss (15e) einen Schieber (11) und ein Schiebergehäuse (10) enthalten.

**15.** Vorrichtung zum kontinuierlichen Nachfüllen einer Verdampferkammer umfassend:

a. eine Vakuumschleuse (19) für festes Material (1),
b. eine an der Vakuumschleuse (19) angebrachte Vakuumkammer (3), wobei die Vakuumkammer (3) mit einer Trennwand (28) versehen ist, welche nur für flüssiges Material (1) durchlässig ist,
c. einen an der Vakuumkammer (3) hinter der Trennwand (28) angebrachten Verbindungskanal (20) in eine Verdampferkammer (8),
d. eine Heizummantelung (29) der Vakuumkammer (3) und des Verbindungskanals (20) und
e. eine schaltbare Kühlvorrichtung (24) am Verbindungskanal (20).

**16.** Verwendung der Vorrichtung nach einem der Ansprüche 10 bis 15 zum kontinuierlichen Nachfüllen einer Verdampferkammer für Schwefel, Selen, Tellur und/oder Gemischen davon bei der Herstellung von Dünnschichtsolarzellen, bevorzugt zum kontinuierlichen Nachfüllen einer Selenverdampferkammer.

FIGUR 1

15

15f

15a     15b          15d     15e

15c

Figur 2

**FIGUR 3**

Überführen von Selen (1) über eine Zuführung (6) und einen geheizten Vakuumschieber (2) in einen Siphon (4) innerhalb einer beheizten Vakuumkammer (3).

Aufheizen des Siphons (4) auf 230 °C und Verflüssigen des Selens (1) bei 5 mbar.

Überführen des Selens (1) über einen mit dem Ausgang des Siphons (4) verbundenen Trichter (7) in eine Wanne (9) innerhalb einer Verdampferkammer (8).

Verdampfen des Selens (1) bei 230 °C und $10^{-5}$ mbar.

FIGUR 4

FIGUR 5

Europäisches
Patentamt

European
Patent Office

Office européen
des brevets

**EUROPÄISCHER RECHERCHENBERICHT**

Nummer der Anmeldung

EP 10 15 7912

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | EP 2 025 773 A1 (APPLIED MATERIALS INC [US]) 18. Februar 2009 (2009-02-18) * das ganze Dokument * ----- | 1-16 | INV. C23C14/24 C23C14/56 |
| A | WO 2005/116290 A1 (SIDRABE INC [LV]; YADIN EDGARS [LV]; PIPKEVICS GRIGORIJS [LV]; ZEILIA) 8. Dezember 2005 (2005-12-08) * das ganze Dokument * ----- | 1-16 | |
| A | JP 2 118064 A (MITSUBISHI HEAVY IND LTD) 2. Mai 1990 (1990-05-02) * Zusammenfassung * ----- | 1-16 | |
| A | WO 2008/040329 A1 (ARDENNE ANLAGENTECH GMBH [DE]; OBST HENRIK [DE]; DEUS CARSTEN [DE]; GO) 10. April 2008 (2008-04-10) * das ganze Dokument * ----- | 1-16 | |
| A | JP 2008 248362 A (FUJIFILM CORP) 16. Oktober 2008 (2008-10-16) * Zusammenfassung * ----- | 15 | RECHERCHIERTE SACHGEBIETE (IPC) C23C |

Der vorliegende Recherchenbericht wurde für alle Patentansprüche erstellt

| Recherchenort | Abschlußdatum der Recherche | Prüfer |
|---|---|---|
| München | 4. August 2010 | Swiatek, Ryszard |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................................................
& : Mitglied der gleichen Patentfamilie, übereinstimmendes
    Dokument

EPO FORM 1503 03.82 (P04C03)

Europäisches
Patentamt

European
Patent Office

Office européen
des brevets

**Nummer der Anmeldung**

EP 10 15 7912

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☒ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☐ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

Europäisches
Patentamt

European
Patent Office

Office européen
des brevets

**MANGELNDE EINHEITLICHKEIT
DER ERFINDUNG
ERGÄNZUNGSBLATT B**

**Nummer der Anmeldung**

EP 10 15 7912

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1-14, 16

   Verfahren und Vorrichtung zum kontinuierlichen Nachfüllen einer Verdampferkammer, wobei Material (1) über eine Zuführung (6) und einen geheizten Vakuumschieber (2) in einen Siphon (4) innerhalb einer beheizten Vakuumkammer (3) überführt wird und Material (1) im Siphon (4) bis zur Verflüssigung aufgeheizt wird.
   ---

2. Ansprüche: 15, 16

   Vorrichtung zum kontinuierlichen Nachfüllen einer Verdampferkammer mit einer Vakuumkammer (3), wobei die Vakuumkammer (3) mit einer Trennwand (28) versehen ist, welche nur für flüssiges Material (1) durchlässig ist.
   ---

**ANHANG ZUM EUROPÄISCHEN RECHERCHENBERICHT
ÜBER DIE EUROPÄISCHE PATENTANMELDUNG NR.**

EP 10 15 7912

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-08-2010

| Im Recherchenbericht angeführtes Patentdokument | Datum der Veröffentlichung | Mitglied(er) der Patentfamilie | Datum der Veröffentlichung |
|---|---|---|---|
| EP 2025773 A1 | 18-02-2009 | WO 2009010468 A1 | 22-01-2009 |
| WO 2005116290 A1 | 08-12-2005 | CN 1950541 A<br>DE 112005001190 T5<br>JP 2008500454 T<br>LV 13383 B | 18-04-2007<br>19-04-2007<br>10-01-2008<br>20-02-2006 |
| JP 2118064 A | 02-05-1990 | KEINE | |
| WO 2008040329 A1 | 10-04-2008 | DE 112007002897 A5<br>EP 2087145 A1<br>KR 20090074064 A | 03-09-2009<br>12-08-2009<br>03-07-2009 |
| JP 2008248362 A | 16-10-2008 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007077171 A2
- EP 0715358 A2
- WO 2009034131 A2
- US 4880960 A
- WO 2009010468 A1